# EUROPÄISCHE PATENTANMELDUNG

(11) **EP 3 657 921 A1**
(43) Veröffentlichungstag der Anmeldung: **27.05.2020**
(21) Anmeldenummer: 18208328.7
(22) Anmeldetag: 26.11.2018
(51) Int. Cl.: H05K 7/20

(54) **SCHALTSCHRANKENTWÄRMUNG**

(71) Anmelder: Siemens Aktiengesellschaft, 80333 München (DE)
(72) Erfinder: Knauer, Hans, 91359 Leutenbach (DE)

(57) **Zusammenfassung**

Die Erfindung betrifft einen Schaltschrank (1) mit:
- einem Schaltschrankgehäuse (2), das elektrische Leistungszugänge, Leistungsabgänge und Kühlungsanschlüsse aufweist, die nach außen führen,
- zumindest einem wärmeerzeugenden Bauelement, wobei ein Bauelement über ein flüssigkeitsdurchströmtes Kühlelement (11) kühlbar ist, wobei das Kühlelement (11) zumindest an der dem Bauelement abgewandten Seite Kühlrippen (9) aufweist,
- zumindest zwei Kühlkreisläufen, wobei ein erster Kühlkreislauf ein flüssigkeitsdurchströmtes Kühlelement (11) aufweist und ein zweiter Kühlkreislauf ein innerhalb des Schaltschrankes (1) geschlossener Kreislauf eines gasförmigen Mediums ist.

## Beschreibung

Die Erfindung betrifft einen Schaltschrank mit einem Schaltschrankgehäuse, das elektrische Leistungsanschlüsse und Kühlmittelanschlüsse aufweist, die nach außen führen.

Stromrichter steuern den Energieaustausch zwischen einem elektrischen Versorgungsnetz und einer elektrischen Maschine. Bei großen Leistungen sind die Stromrichter in einem Schaltschrank angeordnet. Dabei ist das Leistungsteil der Stromrichter in der Regel in diesen Schaltschrank eingebaut. Der Leistungsteil des Stromrichters weist im Wesentlichen Kondensatoren, Drosseln und Halbleiter auf. In demselben Schaltschrank befinden zudem weitere elektrische Komponenten wie Sicherungen, Regelungseinheiten, Schalter, Bedienpanel, Ansteuerbaugruppen, Energieversorgungsbaugruppen, Kommunikationsbaugruppen usw. Oftmals werden diese weiteren Komponenten auch als Hilfskomponenten bezeichnet. Manche dieser Hilfskomponenten, hauptsächlich Komponenten der Informationselektronik, wie beispielsweise Regelungsbaugruppe, Bedienpanel, Kommunikationsbaugruppen, sind lediglich für vergleichsweise niedrige Maximaltemperaturen im Bereich von 60°C bis 65°C zugelassen. Dies gilt auch für Energieversorgungsbaugruppen, beispielsweise für die Ansteuerbaugruppe der Halbleiter.

Mit Steigerung der Leistungsfähigkeit des Leistungsteils der Stromrichter steigen nahezu proportional dazu auch die Verluste, die zu einer weiteren Erwärmung des Schaltschrankes führen. Um aber für den Schaltschrank auch kostengünstige Hilfskomponenten mit einer zulässigen Maximaltemperatur von 60°C bis 65°C nutzen zu können, muss die Kühlung des Stromrichters entsprechend leistungsfähig sein.

So ist aus der DE 200 16 013 U1 ein Schaltschrank mit Wärmeabführung bekannt, welcher ein Gehäuse aufweist, innerhalb dessen mindestens ein wärmeerzeugendes Bauteil und mindestens ein Kühlkörper angeordnet sind, wobei er eine den Innenraum des Schaltschranks in zwei Kammern unterteilende Montageplatte aufweist, eine dieser Kammern eine Kühlluftkammer und die andere Kammer eine Bauteilkammer ist, der mindestens eine Kühlkörper in der Kühlluftkammer und das mindestens eine wärmeerzeugende Bauteil in der Bauteilkammer angeordnet ist und der Kühlkörper durch eine Aussparung in der Montageplatte direkt mit dem wärmeerzeugenden Bauteil kontaktiert ist.

Des Weiteren ist aus der WO 2018/072932 A1 ein Schaltschrank mit einem geschlossenen Gehäuse bekannt und einer Kühlvorrichtung zum Kühlen von im Innern des Gehäuses anordenbaren elektrischen und/oder elektronischen Betriebsmitteln mit einem ersten geschlossenen Kühlkreislauf, der ein erstes Kühlmedium enthält zum Abtransport von Wärme, die im Betrieb von mindestens einem der Betriebsmittel erzeugt wird, aus dem Gehäuse heraus, wobei der erste Kühlkreislauf innerhalb des Gehäuses mit einem ersten Wärmeübertrager zum Übertragen der Wärme von dem mindestens einen Betriebsmittel auf das erste Kühlmedium und außerhalb des Gehäuses mit einem zweiten Wärmeübertrager zum Abgeben der Wärme an ein Außenkühlmedium verbunden ist, wobei der zweite Wärmeübertrager oberhalb des ersten Wärmeübertragers angeordnet ist und wobei der erste Kühlkreislauf, das erste Kühlmedium und der erste und zweite Wärmeübertrager ausgebildet sind, den Wärmetransport nach dem Zweiphasen-Thermosiphon-Prinzip zu realisieren.

Ausgehend davon liegt der Erfindung die Aufgabe zugrunde einem Schaltschrank mit einer verbesserten Wärmeabfuhr bereitzustellen. Des Weiteren soll der Schaltschrank auch für erhöhte IP-Schutzklassen gemäß IEC 34-5 geeignet sein.

Die Lösung der gestellten Aufgabe gelingt durch einen Schaltschrank mit:
- einem Schaltschrankgehäuse, das elektrische Leistungszugänge, Leistungsabgänge und Kühlungsanschlüsse aufweist, die nach außen führen,
- zumindest einem wärmeerzeugenden Bauelement, wobei ein Bauelement über ein flüssigkeitsdurchströmtes Kühlelement kühlbar ist, wobei das Kühlelement zumindest an der dem Bauelement abgewandten Seite Kühlrippen aufweist,
- zumindest zwei Kühlkreisläufen, wobei ein erster Kühlkreislauf ein flüssigkeitsdurchströmtes Kühlelement aufweist und ein zweiter Kühlkreislauf ein innerhalb des Schaltschrankes geschlossener Kreislauf eines gasförmigen Mediums ist.

Der erfinderische Aufbau des Schaltschranks beinhaltet nunmehr, dass das Leistungsteil durch eine Flüssigkeitskühlung, insbesondere ein Kühlelement gekühlt wird. Das Leistungsteil setzt sich aus wesentlichen Komponenten eines Stromrichters zusammen und weist Bauelemente wie Halbleiter, Kondensatoren und/oder Drosseln auf. Das Kühlelement bildet dabei, zumindest zum Teil eine Gehäusewand des Leistungsteils. Damit sind diese elektrischen Komponenten, also die Wärmequellen näher oder zumindest einseitig direkt an dem Kühlelement, insbesondere einer Kühlplatte angeordnet und thermisch gekoppelt.

Die von den Leistungsteilen nicht beanspruchten bzw. belegten Flächen des Kühlelements werden von einem gasförmigen Kühlstrom überstrichen. An diesen nicht belegten Flächen bzw. Seiten sind zumindest abschnittsweise Kühlrippen zur Oberflächenvergrößerung des Kühlelements vorgesehen.

Aufgrund dieser Anordnung kann nunmehr diese Oberfläche des Kühlelements als thermische Schnittstelle zu einem internen Schrankwärmetauscher, also einem zweiten Kühlkreislauf genutzt werden. Dieser Wärmetauscher wird erfindungsgemäß dadurch realisiert, indem Kühlrippen mit dem Kühlelement thermisch leitend verbunden sind, und damit zu einer Kühlung eines umwälzten gasförmigen Mediums führen. Es erfolgt eine thermische Kopplung zwischen diesem gasförmigen Medium und der Oberfläche des Kühlelements, die vorteilhafterweise durch diese angeordneten Kühlrippen vergrößert ist und damit einen Rückkühleffekt des umwälzten gasförmigen Mediums verbessert.

Die thermische Anbindung der Kühlrippen an das Kühlelement kann durch eine mechanische Verbindung, von einem stranggepressten Kühlkörper mit dem Kühlelement oder auch durch das direkte Einbringen einzelner oder auch gruppenmäßig zusammengefassten Kühlrippen in ein vorgebbares Profil des Kühlelements erfolgen.

An diesen ev. Übergangsstellen kann mittels eingesetzter Wärmeleitpaste der thermische Übergang verbessert werden.

Durch das Abdecken der Kühlrippen mittels einer Platte oder einer Haube kann ein vorzugsweise strömungstechnisch günstiger Kühlkanal gebildet werden, der im Bereich der Schrankunterseite und im Bereich der Schrankoberseite Öffnungen aufweist zum Ansaugen bzw. Ausblasen des gasförmigen Mediums innerhalb des Schaltschrankes. Das gasförmige Medium ist vorzugsweise Luft, kann aber auch andere Gase oder Gasmischungen enthalten.

Um die thermische Konvektion zu forcieren, kann der Kühlkanal des zweiten Kühlkreislaufes ein oder mehrere Lüfter aufweisen. Die elektrische Speisung der Lüfter erfolgt über das Leistungsteil der im Schaltschrank vorhandenen Stromversorgung, so dass keine separate und zusätzliche Versorgungsleitung für die Lüfter notwendig ist. Mit dem oder den Lüftern wird im Schaltschrank ein Luftstrom mittels eines oder mehrerer Luftschotts gezielt auf Verlusterzeuger, also Wärmequellen gelenkt. Mittels des gezielten Kühlstroms erfolgt ein Wärmetransport der von den Schrankkomponenten an die Luft abgegebenen Abwärme letztlich über die Kühlrippen der Kühlelemente in den Flüssigkeitskühlkreislauf und kann von dort außerhalb des Schaltschrankes geführt werden.

Der Einsatz zusätzlicher Lüfter oder Wärmetauscher mit den dafür notwendigen Komponenten wie z.B. zusätzliche Schrankstromversorgung für Lüfter oder weitere Kühlkreisläufe innerhalb des Schrankes für einen Wärmetauscher, sind somit nicht mehr notwendig.

Dies führt zu einer Kosteneinsparung und auch zu einer Reduktion der Komplexität dieses Schaltschranksystems bei gleichzeitig verbesserter Kühlleistung.

Damit ist der Schaltschrank auch für erhöhte IP-Schutzklassen gemäß IEC 34-5 geeignet.

Des Weiteren kann die verbleibende Restwärme bei diesem flüssigkeitsgekühlten System, in Verbindung mit Lüftern oder Luftwärmetauschern in den Schaltschränken reduziert werden. Damit reduzieren sich auch die Unterhaltungskosten für die Klimatisierung der Schalträume, in denen sich diese Schaltschränke befinden.

Die Erfindung sowie vorteilhafte Ausgestaltungen der Erfindung werden anhand von Ausführungsbeispielen näher dargestellt, darin zeigen:
- FIG 1: einen Schaltschrank in Seitenansicht,
- FIG 2: einen Querschnitt des Schaltschranks,
- FIG 3: eine weitere Prinzipdarstellung eines Schaltschranksystems,
- FIG 4: eine Detaildarstellung.

Schaltschränke 1 stehen mehr oder weniger im Freien oder in dafür ausgelegten Schalträumen. In die Schaltschränke 1 führen Stromschienen 14 oder andere Leistungsanschlüsse bzw. Leistungsabgänge. Des Weiteren sind Kühlanschlüsse 21,22 vorgesehen.

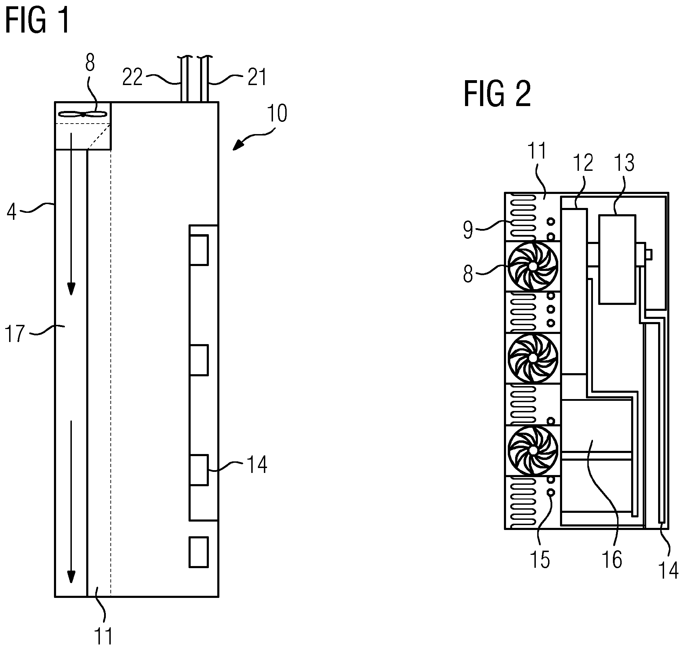

FIG 1 zeigt in einem Längsschnitt die Anordnung eines Leistungsteils 10 ohne den zugehörigen Schaltschrank 1. Dabei sind Kühlanschlüsse, also Kühlflüssigkeitszugänge 21 und Kühlflüssigkeitsabgänge 22 dargestellt, die die Leistungsteile 10, insbesondere Halbleiter 12 und Zwischenkreiskondensatoren 16, gegebenenfalls Drossel und weitere vergleichsweise starke Wärmequellen des Leistungsteils 10 kühlen. Einige oder alle davon sind thermisch an ein oder mehrere Kühlelemente 11 gekoppelt.

Zumindest die Halbleiter 12, als auch die Zwischenkreiskondensatoren 16 sind gemäß FIG 2 direkt mit einem Kühlelement 11, das als Kühlplatte ausgeführt ist, thermisch kontaktiert. Die Abwärme aus den Wärmequellen des oder der Leistungsteile 10, insbesondere aus dem Halbleiter 12 und den Kondensatoren 16 wird dabei überwiegend direkt in das Kühlelement 11 übertragen das mit Kühlkanälen 15 versehen ist.

Dabei kann die Anzahl der Kühlkanäle 15 im Bereich der Halbleiter 12 bezüglich ihrer Dichte und/oder Durchmesser höher ausgelegt sein. Für diese Auslegung ist dabei ist jeweils die abzuführende Wärmemenge aus diesem Bereich entscheidend. Auf der den Halbleitern 12 und den Kondensatoren 16 abgewandten Seite des Gehäuses des Kühlelements 11 befinden sich Rippen 9, um die auf dieser Seite befindliche Oberfläche des Kühlelements 11 zu vergrößern. Damit wird nunmehr ermöglicht, dass der im Schaltschrank 1 geschlossene Luftkreislauf sich vor allem über die Rückseite des Kühlelements 11 und den daran befindlichen Rippen 9 abkühlt und somit eine Rückkühlung des im Schaltschrank 1 umlaufenden Kühlluftstroms 20 herbeigeführt wird. Durch die Flüssigkeitskühlung des Kühlelements 11 werden somit vor allem die aktiven Wärmequellen des Leistungsteils 10, als auch der Kühlluftstrom 20 rückgekühlt der u.a. die weiteren elektrischen Komponenten wie Sicherungen, Regelungseinheiten, Schalter, Bedienpanel, Ansteuerbaugruppen, Energieversorgungsbaugruppen, Stromwandler 13, Kommunikationsbaugruppen usw. kühlt.

Durch den im Schaltschrank 1 umwälzten Kühlluftstrom 20 werden zumindest zu einem gewissen Teil auch die Leistungsteile 10, wie Halbleiter 12, Zwischenkreiskondensatoren 16, und gegebenenfalls Drosseln gekühlt.

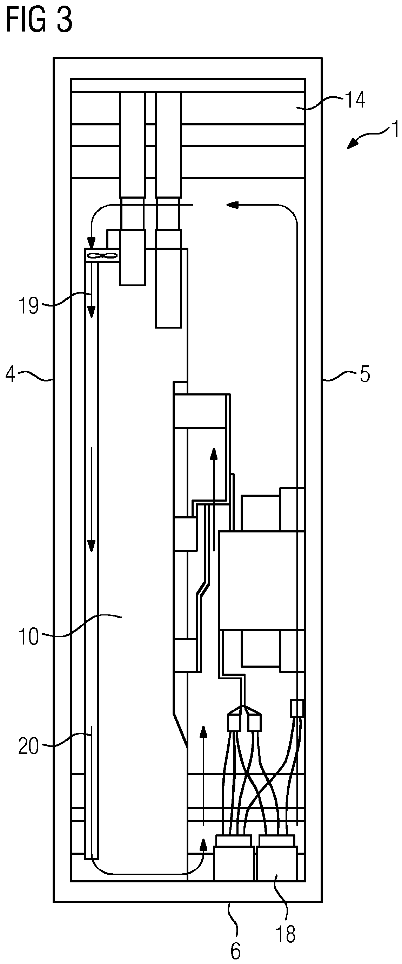

FIG 3 zeigt nunmehr das Leistungsteil 10 innerhalb eines Schaltschranks 1, der durch ein Schaltschrankgehäuse 2 begrenzt wird, dass sich aus Seitenteilen 3, einem Frontteil 4 einem Rückseitenteil 5, als auch einem Basisteil 6 und Deckteil 7 zusammensetzt. Ein Motorkabel 18 bildet einen Leistungsabgang der Leistungsteile 10 zu einem elektrischen Motor beispielsweise durch das Basisteil 6. Der Leistungszugang in den Schaltschrank 1 erfolgt vorzugsweise durch den gleichen Gang.

Den Kühlluftstrom 20 innerhalb des Schaltschranks 1 können nunmehr ein oder mehrere Lüfter 8 bewerkstelligen. Die Leistung der Lüfter 8 wird dabei direkt aus dem Leistungsteil 10 des Schaltschrankes 1 selbst bezogen.

Damit weist der Schaltschrank 1 nach außen lediglich Leistungsanschlüsse und Flüssigkeitsanschlüsse für die Kühlflüssigkeit zu einem externen Wärmetauscher auf. Damit gelingt eine vergleichsweise einfache Abschottung, so dass der Schaltschrank 1 auch für erhöhte IP-Schutzklassen gemäß IEC 34-5 geeignet ist.

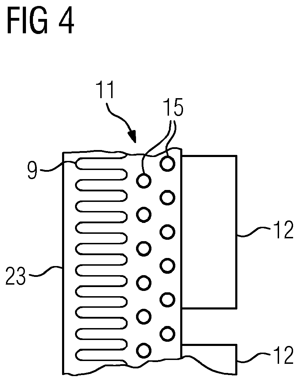

FIG 4 zeigt in einer Detaildarstellung eine mögliche Ausführung des Kühlelements 11. Das Kühlelement 11 ist als Kühlplatte ausgeführt und mit einer Vielzahl von Kühlkanälen 15 versehen. Diese Kühlkanäle 15 können innerhalb des Kühlelements 11 beliebig angeordnet sein. Sie werden jedoch vorzugsweise möglichst nahe an der Wärmequelle angeordnet werden. Ebenso können die Kühlkanäle 15 parallel und/oder seriell "geschaltet" sein. Der über die Rippen 9 streichende Luftstrom 20 wird mittels einer Abdeckung 23 im Bereich der Rippen 9 zusätzlich geführt, um einen dementsprechenden Wärmeübergang des Luftstroms 20 auf das Kühlelement 11 zu gewährleisten. Die Abdeckung 23 kann auch durch das Frontteil 4, also beispielsweise eine Tür des Schaltschrankgehäuses 2 gebildet sein.

Erfindungsgemäß weist das Kühlelement 11 nunmehr folgende Funktionen auf. Es dient der effizienten Kühlung der hauptsächlichen Wärmequellen in dem Schaltschrank 1, also Elementen der Leistungsteile 10, wie Halbleiter 12, Kondensatoren 16 usw., die direkt wärmeleitend mit dem Kühlelement 11 verbunden sind. Des Weiteren wird an den "freien" Kühlflächen des Kühlelements 11, also Flächen, die nicht von den Elementen der Leistungsteile 10 eingenommen werden, ein im Schaltschrank 1 umwälzter Kühlluftstrom 20 durch das gleiche Kühlelement 11 rückgekühlt.

Damit wird bei einer effizienten Kühlung eines Schaltschrankes 1 die Anzahl der Zu- und Abgänge über das Schaltschrankgehäuse 2 minimiert, was den Schaltschrank 1 auch für erhöhte IP-Schutzklassen gemäß IEC 34-5 geeignet macht.

## Patentansprüche

1. Schaltschrank (1) mit:
- einem Schaltschrankgehäuse (2), das elektrische Leistungszugänge, Leistungsabgänge und Kühlungsanschlüsse aufweist, die nach außen führen,
- zumindest einem wärmeerzeugenden Bauelement, wobei das Bauelement mittels einem flüssigkeitsdurchströmten Kühlelement (11) kühlbar ist, wobei das Kühlelement (11) zumindest an der dem Bauelement abgewandten Seite Kühlrippen (9) aufweist,
- zumindest zwei Kühlkreisläufen, wobei ein erster Kühlkreislauf ein flüssigkeitsdurchströmtes Kühlelement (11) aufweist und ein zweiter Kühlkreislauf ein innerhalb des Schaltschrankes (1) geschlossener Kreislauf eines gasförmigen Mediums ist.

2. Schaltschrank (1) nach Anspruch 1, **dadurch gekennzeichnet, dass** das flüssigkeitsdurchströmte Kühlelement (11) wärmetechnisch leitend unmittelbar direkt mit einem oder mehreren Bauelementen verbunden ist.

3. Schaltschrank (1) nach Anspruch 1 oder 2, **dadurch gekennzeichnet, dass** das flüssigkeitsdurchströmte Kühlelement (11) Teil einer Schaltschrankoberfläche bildet.

4. Schaltschrank (1) nach einem der vorhergehenden Ansprüche, **dadurch gekennzeichnet, dass** das flüssigkeitsdurchströmte Kühlelement (11) zumindest auf einer Seite, insbesondere auf der den Bauelementen abgewandten Seite Kühlrippen (9) aufweist.

5. Schaltschrank (1) nach einem der vorhergehenden Ansprüche, **dadurch gekennzeichnet, dass** der zweite Kühlkreislauf an den Kühlrippen (9) des Kühlelements (11) rückgekühlt wird.

6. Schaltschrank (1) nach einem der vorhergehenden Ansprüche, **dadurch gekennzeichnet, dass** der erste Kühlkreislauf zumindest zum Teil durch Flüssigkeitskühlkanäle (15) im Kühlelement (11) gebildet ist.
